# EUROPEAN PATENT SPECIFICATION

(11) **EP 2 204 910 B1**
(45) Date of publication and mention of the grant of the patent: **03.07.2013**
(21) Application number: 08254184.8
(22) Date of filing: 30.12.2008
(51) Int. Cl.: H03M 1/80

(54) **Digital to analogue converter**
Digital-Analog-Umsetzer
Convertisseur numérique-analogique

(43) Date of publication of application: 07.07.2010
(73) Proprietor: ST-Ericsson SA, 1228 Genève Plan-les-Ouates (CH)
(72) Inventor: Vilhonen, Sami, 21420 Lieto (FI); Eskola, Rami, 20100 Turku (FI)
(74) Representative: Style, Kelda Camilla Karen

(56) References cited:
- US-A- 5 856 799
- US-A1- 2008 285 676
- US-B1- 6 690 313

## Description

The present invention relates to a digital to analogue converter, including, but not limited to a digital to analogue converter for use in wireless transmitters.

Digital to Analogue Converters (DACs) are used in a very wide range of applications. For example, DACs may be used in wireless transmitters to convert digital signals generated by the transmitter's baseband to appropriate analogue signals for transmission by an antenna. In a typical transmitter, a digital signal is first converted to an analogue signal using a DAC, and then the analogue signal is passed through filtering, mixing and amplification stages before power amplification and finally transmission is performed.

US6690313 discloses a digital signal provided to an analogue-to-digital upconverter through digital signal processing circuitry. A sample rate signal and a divided sample rate signal are provided by a divider chain using a dock input. The divided sample rate signal is used to drive a decoder circuit. The digital outputs of the decoder circuit are combined with the sample rate signal in a mixer which in turn generates a digitally upconverted signal which drives a plurality of switches combined together to form the analogue output.

One problem with existing techniques is that the large number of functional blocks required to process the signals requires a large silicon area on the transmitter integrated circuit (TXIC). Another problem is that the amount of analogue signal processing required is large. These problems make it more difficult to implement transmitters using, for example, modern Complimentary Metal Oxide Semiconductor (CMOS) techniques.

In many wireless transmitter designs, such as those used in mobile telephones, it is often necessary to minimise power consumption, and therefore to use a low voltage power supply. However, the reliance on the performance of many analogue components in existing designs results in either increased power consumption requirements, or reduced performance in low power designs.

According to one aspect there is provided a circuit for converting a digital value into an analogue signal, the circuit comprising: a logic block arranged to receive one or more digital signals representing the digital value and each one or more digital signals having a relative weighting, the logic block being further arranged to output one or more signals, each of said one or more output signals comprising an oscillator signal modulated by a respective digital signal; a generating means for generating the analogue signal representative of the digital value, the analogue signal comprising a weighted combination of the one or more signals output from the logic block, wherein said generating means comprises a series of amplitude modifiers each associated with a respective one of said one or more output signals and arranged to relatively weight, based on the relative weightings of the respective digital signals, the relative amplitudes of the respective one or more output signals output from the logic block characterised by a matching circuit for matching the output impedance of said circuit to a value, wherein an input impedance of said circuit is lower than said matched output impedance value.

Embodiments of the invention will now be described, by way of example only, with reference to the Figures, in which:
Figure 1 is a block diagram of a system comprising a wireless transmitter;
Figure 2 is a block diagram illustrating the RFIC shown in Figure 1 in more detail;
Figure 3 is a block diagram of a system, according to an embodiment of the invention, comprising a wireless transmitter;
Figure 4 is a schematic diagram of the DAC module shown in Figure 3;
Figure 5 is a circuit diagram of the matching circuit shown in Figure 4;
Figure 6 is a circuit diagram of one embodiment of the DAC shown in Figure 4; and
Figure 7 is a circuit diagram of another embodiment of a DAC.

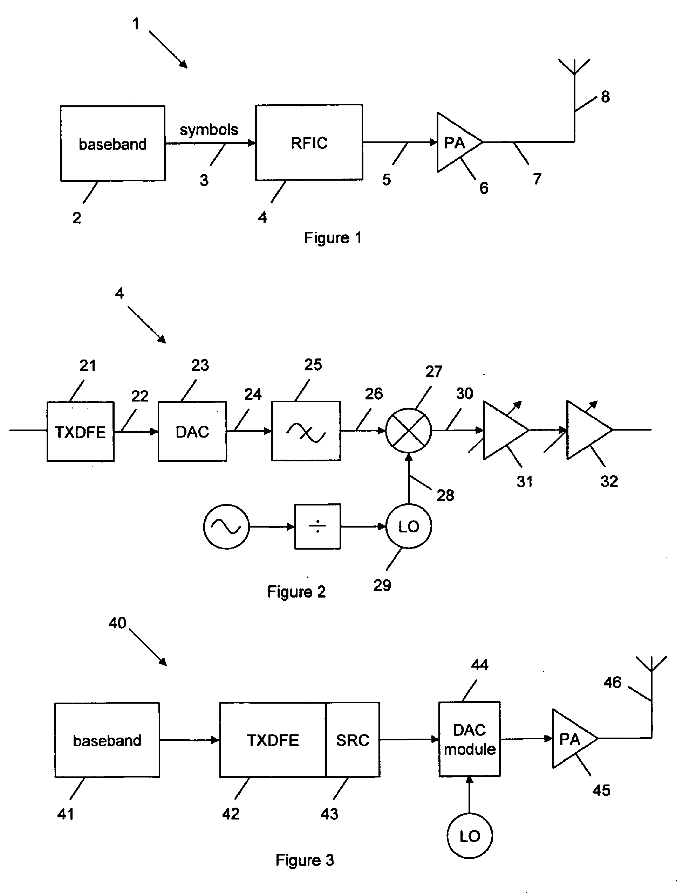

Figure 1 is a block diagram of a system comprising a wireless transmitter, for example used in a mobile telephone. The transmitter 1 comprises a baseband section 2 which generates and outputs digital data in the form of symbols to a Radio-Frequency Integrated Circuit (RFIC) 4 on line 3. The symbols represent the digital data that is to be transmitted by the transmitter and is derived from signals received by the baseband section 2 from one or more input devices (not shown) such as a keyboard and a microphone. The baseband section 2 processes these signals to generate the digital data. The RFIC 4 performs various processing of the digital data generated by the baseband section 2, including converting the digital data into an analogue signal 5 suitable for transmission. The RFIC 4 also performing filtering, mixing and amplification of the analogue signal. The processed analogue signal 5 generated by the RFIC 4 is provided to a Power Amplifier (PA) 6 which performs further amplification of the signal before the amplified signal 7 is transmitted by an antenna 8.

Figure 2 illustrates the RFIC 4 shown in Figure 1 in more detail. The symbols 3 received by the RFIC 4 from the baseband section 2 are first provided to a Transmitter Digital Front End (TXDFE) block 21. This block 21 performs any remaining digital pre-processing required before digital to analogue conversion takes place. The output 22 of the TXDFE 21 is then provided to a DAC 23 which converts the digital data into an analogue signal 24. The analogue signal then passes through separate filtering, mixing and amplification stages. In particular, the analogue signal 24 is first passed through a filter 25. The signal is then converted up to RF frequency by mixing the signal with a Local Oscillator (LO) signal. The mixing stage is performed by a mixer 27 which receives the LO 29 output, derived, for example, by dividing an appropriate oscillator signal. The RF signals 30 output by the mixer 27 are then passed to an amplification stage which includes at least two amplifiers 31, 32. These amplifiers 31, 32 perform gain control, and provide an output of the RFIC. As seen in Figure 1, the output of the RFIC is further amplified by PA 6 before being transmitted.

It can be seen from Figure 2 and from the foregoing that there are a significant number of analogue components in this arrangement and that the amount of analogue signal processing performed by the RFIC is relatively high. Figure 3 is a block diagram of a system comprising a wireless transmitter in which the number of analogue components may be reduced, resulting in less analogue processing and a smaller silicon area.

The transmitter 40 shown in Figure 3 comprises a baseband section 41, a TXDFE 42, a module referred to as DAC module 44, a PA 45 and an antenna 46. As before, the baseband section 41 generates symbols representing digital data to be transmitted. The symbols are provided to the TXDFE 42 for processing. In the illustrated embodiment, the TXDFE includes a Sample-Rate-Converter (SRC) 43 which is arranged to increase or decrease the sample rate of the digital data as required. For example, in some embodiments, the DAC module 44, described in greater detail below, may require a specific sample rate which is not provided by the baseband section 41 and TXDFE 42. As will be appreciated by the skilled person, the SRC represents a relatively minor modification to the TXDFE.

The DAC module 44 receives the digital data and produces an output in the form of an analogue signal as described in greater detail below. The DAC module 44 therefore performs the digital to analogue conversion of the data. This is performed in such a way, however, that the amount of analogue processing and power consumption may be minimised. The analogue signal generated by the DAC module 44 is provided to the PA 45 which amplifies the signal before providing it to the antenna 46 for transmission.

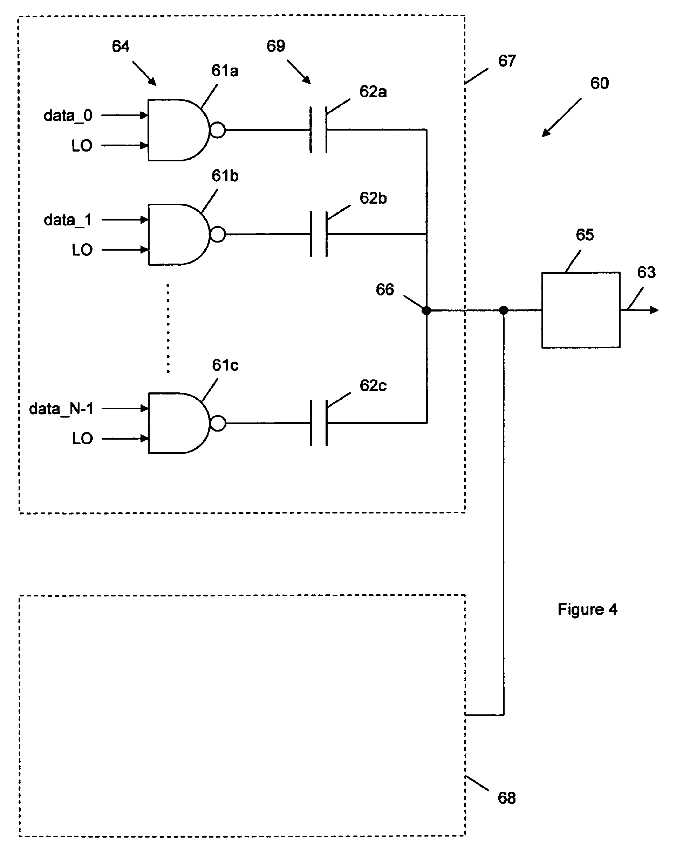

The DAC module 44 comprises a digital to analogue converter (DAC), one embodiment of which is illustrated in more detail in Figure 4. In general, the DAC receives a series of one or more digital signals representing a value. For example, the signals may represent bits of a binary number, or may represent a thermometer-coded value. In the first example, the signals have different weights corresponding to the binary weighting of the individual bits. In the second example, the signals each have equal weight.

The DAC comprises a first stage, which may be referred to as a logic block 64, which converts each digital signal to radio-frequency. Each radio-frequency signal is generated by modulating an oscillator signal of certain frequency with a respective digital signal. This may be performed, for example, by multiplying the oscillator signal with the digital signal using a NAND, AND, OR, NOR, XOR or XNOR gate, series switches, or any other suitable means. For example, in the case of NAND, AND, OR and NOR gates, the result is a signal which is substantially constant when the digital signal is in a first state (e.g. a high or low state), and is an oscillating signal when the digital signal is in a second state (e.g. a low or high state).

The DAC also comprises a second stage, which may be referred to as generating means 69, which performs digital to analogue conversion. In the second stage, the radio-frequency signals are combined together to produce an analogue signal whose amplitude is representative of the input value. For example, the analogue signal comprises a weighted sum, or other suitable combination, of the individual radio-frequency signals. The weighting used in the summation or combining of the signals depends on the weight of the respective input digital signals. For example, if the input signals represent a binary number, the radio-frequency signals are added with binary weighting whereas if a thermometer-code is used, the radio-frequency signals are added with equal weighting. In various embodiments, capacitors, resistors, inductors or any other suitable means may be used to control the relative amplitude of the individual radio-frequency signals. The resulting amplitude-modulated signals may be added together.

The specific embodiment of the DAC illustrated in Figure 4 will now be described. In this embodiment, DAC module 60 receives a stream of N-bit binary values and produces an analogue signal therefrom. The stream of binary values corresponds to the digital data stream output by the TXDFE and SRC 43. In practice, the data stream comprises both I and Q components. The DAC illustrated in Figure 4 comprises two stages. The first stage transfers the digital data from IQ data frequency to RF frequency bit by bit. The second stage performs the actual digital to analogue conversion.

The DAC module 60 comprises a series of NAND gates 61a-c, each one associated with a respective bit of a received binary value. There are therefore as many NAND gates 61a-c as the number of bits in each received binary value, although only three gates 61a-c are shown in the Figure. Each NAND gate 61a-c processes a respective signal representing one bit of the received value to transfer that signal to RF frequency. To achieve this, each NAND gate receives an LO signal as a first input. The LO signal may be, for example, a sine wave or square wave of a certain frequency. The second input of each NAND gate 61 a-c comprises a respective bit of the N-bit binary value. For example, the first NAND gate 61a receives bit 0 of the N-bit binary value, the next NAND gate 61b receives bit 1 of the value, and so on, until the last NAND gate 61c receives bit N-1 of the value. When the data bit input into one of the NAND gates is equal to 1 then the output of that NAND gate will be equal to an inverted version of the LO signal. If the data bit has a value of 0, then the output of the NAND gate will be equal to 1. In this way, the resulting output of the NAND gates 61a-c represents the digital data (i.e. respective binary values) transferred to RF frequency. These signals are used to drive the next stage. As mentioned above, the NAND gates may be replaced with any other suitable component to multiply the LO signal with the digital signal.

The actual digital to analogue conversion is performed by using the RF frequency signals output from the NAND gates 61a-c to drive a series of respective weighted capacitors 62a-c. The output of each NAND gate 61a-c is connected to one plate of a respective capacitor 62a-c and the other plate of each capacitor 62a-c is connected to a common adding point 66. The adding point 66 is, in turn, connected (via a matching circuit discussed below) to an output node 63 representing the output of the DAC module 60. The value of each capacitor 62a-c is binary weighted according to the binary weight of the particular data bit involved in driving the capacitor. For example, the capacitor connected to the output of the NAND gate that receives bit n of the binary value has a capacitor value of 2ⁿ·C, where C is a reference value selected according to the desired relative magnitude of the output signal. In this example, the least significant bit is numbered as bit zero, so that the bits of the N-bit value are numbered from 0 to N-1. The result is that the relative amplitudes of the radio-frequency signals output from the NAND gates are modified according to the binary weighting of the respective bits of the binary value. The common adding point then acts to add or combine the amplitude-modulated signals. Each data bit therefore contributes to the signal at the common adding point according to the bit value (e.g. 0 or 1), but also to the weight of the corresponding capacitor, which in turn depends on the binary weight of the bit in question. The resulting analogue signal occurring at the common adding point 66 therefore has a magnitude that is proportional to the binary value. As a stream of binary values are input into the DAC module 60, the magnitude of the analogue signal will vary accordingly.

The weighting of the capacitors is chosen depending on the coding used to represent the value. In the example above, a binary representation of the value is used so the capacitors are binary weighted. However, if thermometer coding is used such that the input signals are of equal weight then the radio-frequency signals are combined with equal weight. In this case, weighted capacitors may not be required. It is also understood that the capacitors may be replaced with any other suitable component to modify the amplitude of the radio-frequency signals, such as resistors or inductors. The signals may also be combined by means other than the common adding point illustrated in Figure 4.

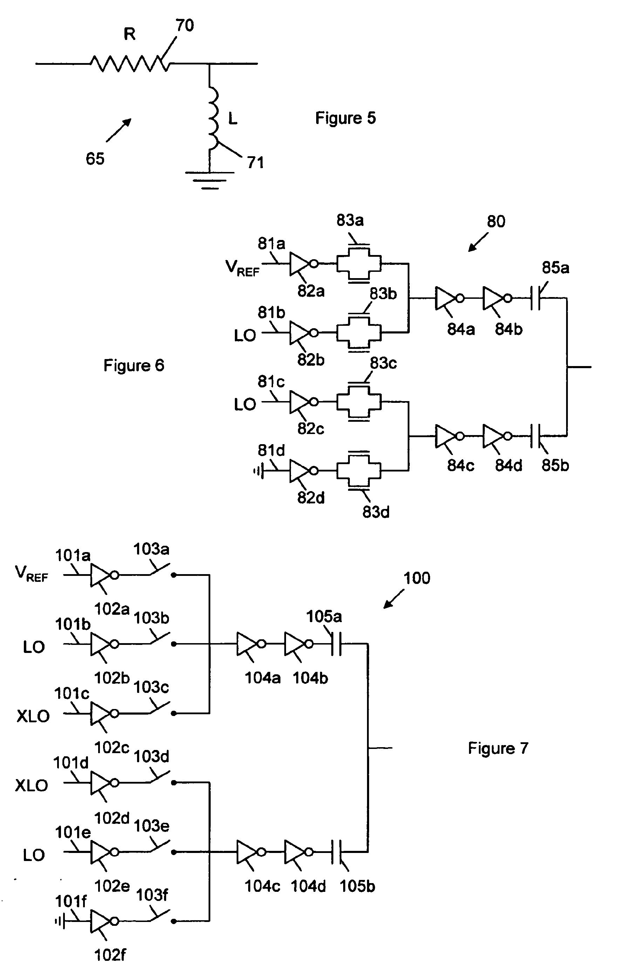

In the embodiment shown in Figure 4, a matching circuit 65 is connected between the common adding point 66 and the output node 63. The matching circuit is used to match the impedance of the DAC module 60 to a particular value. For example, in one embodiment, the matching circuit is arranged to match the capacitive impedance of the DAC module 60 to a value of 50Ω. By ensuring that the input impedance is lower than the output impedance, an increase in voltage at the output may be achieved, resulting in improved performance. The matching circuit may be of any suitable design, one of which is illustrated in Figure 5. This matching circuit 65 comprises a resistor 70 connected between the common adding point and the output node and an inductor 71 connected between the output node 63 and ground. The values of the inductor 71 and resistor 70 may be chosen, for example, so that an impedance of 50Ω is achieved. It is understood that other matching circuits could be used, for example one using a capacitor and inductor in place of the inductor 71 and resistor 70 shown in Figure 5.

Figure 4 illustrates the I-branch 67 of the DAC module 60 in detail. In practice, for image rejection, a Q-branch 68 is also provided. The Q-branch comprises the same circuit as the I-branch. However, the LO signals received by the NAND gates of the Q-branch are 90° out of phase with the LO signals received by the NAND gates of the I-branch. The I-branch receives the I component of the digital data while the Q-branch receives the Q component of the digital data. As seen in Figure 4, the common adding point of the I-branch and the common adding point of the Q-branch are connected at a point prior to the matching circuit.

Although weighted capacitors are used in the illustrated embodiment, one or more of the weighted capacitor could alternatively be replaced by a series of capacitors together having an equivalent capacitance. For the purpose of embodiments of the invention, a group of capacitors that are connected together such that an overall capacitance is achieved may be regarded simply as a single capacitor having the overall capacitance. In one embodiment, the capacitors are in the form of Metal-Oxide-Metal (MOM) capacitors, although it is understood that other forms of capacitor could be used. The performance of the DAC module 44 is characterised by the capacitor values, and the accuracy of the digital to analogue conversion depends on the matching of the capacitors. In practice, matching of the capacitors can be performed accurately.

Figure 6 illustrates one possible implementation of the DAC module 60 shown in Figure 4. The circuit 80 shown in Figure 5 is equivalent to a single NAND gate and capacitor branch of the arrangement shown in Figure 4, for example NAND gate 61a and capacitor 62a. The circuit 80 comprises four inputs 81 a-d. The first input 81a is connected to a reference voltage V_{REF} (not shown in Figure 4), the second 81b and third 81c inputs are connected to the LO signal and the fourth input 81d is connected to ground (not shown in Figure 4). The four inputs 81a-d are connected respectively to four respective inverters 82a-d which invert the respective input signals. The output of each inverter 82a-d is connected to a respective switch, which in the illustrated embodiment are the form of transistor switches 83a-d. Each switch is controlled by the data bit corresponding to this branch of the DAC module, which in this example is bit 0 of the binary value. Each switch 83a-d is controlled by the same data bit. For example, when the data bit is equal to 0 then the inverted inputs are not allowed to pass through the switches, and if the data bit is equal to 1 then the inverted signals are allowed to pass through the switch.

The outputs of switches 83a and 83b are each connected to two inverters 84a, 84b in series. The outputs of switches 83c and 83d are each connected to two further inverters 84c, 84d in series. The two outputs of the two series of inverters 84a, 84b and 84c, 84d are connected to one plate of respective capacitors 85a, 85b. These two capacitors in parallel are equivalent to one of the capacitors 62 illustrated in Figure 4. The other plates of each capacitor 85a, 85b are connected together and to an output of the circuit.

As previously mentioned, the circuit shown in Figure 6 corresponds to a single NAND gate and capacitor connected in series. Therefore, N copies of the circuit shown in Figure 6 are used to implement each of the I-branch 67 and Q-branch 68 of the DAC module 60. The outputs of the N copies of the circuit shown in Figure 6 forming the I or Q branch are connected together at the common adding point 66.

In the embodiments described above, the digital values are unsigned values, each having a magnitude but not a sign (i.e. positive or negative). However, in other embodiments, the digital values may be signed values, each having both a magnitude and a sign. The sign of a value may be represented in any suitable way, for example using a sign bit whose value represents whether the value is positive or negative. One embodiment in which signed values are used will now be described. This embodiment is similar in design to the embodiment illustrated in Figures 4 to 6. However, rather than using an oscillator signal as described, either a non-inverted oscillator signal (referred to below as LO) or an inverted oscillator signal (referred to below as XLO) is used depending on the sign of the value. In an embodiment in which the oscillator signal is a square wave oscillating between high and low states, the inverted oscillator signal comprises a square wave having a low state when the non-inverted oscillator signal has a high state, and having a high state when the non-inverted oscillator signal has a low state. In an embodiment in which the oscillator signal is a sine wave, the inverted oscillator signal comprises a sine wave having the opposite sign. A non-inverted oscillator signal and inverted oscillator signal may be derived from the same oscillator source.

In one embodiment, a sign module is provided to determine the sign of the digital value provided to the DAC module 60, for example by examining the state of the sign bit, and then to selectively provide a non-inverted oscillator signal or inverted oscillator signal depending on the sign. For example, if the value is positive then the sign module provides a non-inverted oscillator signal generated by an oscillator as an output. The sign module is also arranged to invert the oscillator signal generated by the oscillator, and if the value is negative then the sign module provides the inverted oscillator signal as an output. The non-inverted oscillator signal or inverted oscillator signal output by the sign module is provided to circuitry similar to that shown in Figure 4 in place of the oscillator signal (LO) shown. If a stream of signed digital values are input into the DAC module 60 then the oscillator signal provided to the circuitry shown in Figure 4 may switch between a non-inverted oscillator signal and an inverted oscillator signal according to the changing sign of the input values.

Figure 7 illustrates one possible implementation of the DAC module 60 in which signed values are used. This arrangement is similar to that shown in Figure 6 except for modifications allowing either a non inverted oscillator signal (LO) or an inverted oscillator signal (XLO) to be used. As before, only a single branch of the DAC, representing the circuitry for processing a single bit of the value, is illustrated. Similar branches (not shown) are also provided for each other bit of the value representing the magnitude of the value, and the resulting individual signals are then combined to derive the analogue signal as described above.

The circuit 100 comprises six inputs 101 a-f. The first input 101a is connected to a reference voltage V_{REF} and the sixth input 101f is connected to ground. The second 101b and fifth 101e inputs are connected to an LO signal source, and the third and fourth inputs are connected to an XLO signal source. The six inputs 101a-f are connected to six respective inverters 102a-f which invert the respective input signals 101 a-f. The output of each inverter 102a-f is connected to a respective switch 103a-f, which may be, for example, in the form of transistor switches.

Each switch 103a-f is controlled using the data bit corresponding to this branch of the DAC module 60, and therefore each switch 103a-f in this branch is controlled using the same data bit. In the case of the first and sixth switches 103a, 103f, when the data bit is equal to 0 then the inverted inputs are not allowed to pass through the switches, and if the data bit is equal to 1 then the inverted signals are allowed to pass through the switch. The other switches 103b-e are controlled not only by the data bit, but also by the sign bit of the value. Specifically, if the sign bit is equal to 0 then inverted XLO signals are not allowed to pass through respective switches 103c, 103d regardless of the value of the data bit, while inverted LO signals are allowed to pass through respective switches 103b, 103e only if the data bit is equal to 1. If the sign bit is equal to 1 then inverted LO signals are not allowed to pass through respective switches 103c, 103d regardless of the value of the data bit, while inverted XLO signals are allowed to pass through respective switches 103b, 103e only if the data bit is equal to 1.

The outputs of switches 103a-c are each connected to two inverters 104a, 104b in series. The outputs of switches 103d-f are each connected to two further inverters 104c, 104d in series. The two outputs of the two series of inverters 104a-d are connected to one plate of respective capacitors 105a, 105b. The other plates of each capacitor 105a, 105b are connected together and to an output of the circuit 100. It can be seen that the circuit illustrated in Figure 7 functions in the same way as the circuit illustrated in Figure 6 except that LO signals 101b, 101e or XLO signals 101c, 101 d are selectively used, instead of an unconditional LO signal 81 b, 81 c, depending on the sign of the digital value. As with the arrangement shown in Figure 6, the output of the circuit shown in Figure 7 is combined with the outputs of the similar circuits corresponding to the other data bits to produce the analogue signal corresponding to the digital value.

In embodiments of the invention in which digital values are signed, the range of values that may be used is doubled.

As can be seen from the foregoing, the structure of the DAC module 60 is relatively simple. Furthermore, a smaller number of analogue components are required relative to known devices resulting in reduced analogue processing.

For example, the NAND gates 61a-c are digital components. Embodiments of the invention provide a DAC in which power consumption, noise and silicon area may be reduced.

While various exemplary embodiments of the invention have been described above, the skilled person will appreciate that various modifications are possible.

## Claims

1. A circuit for converting a digital value into an analogue signal, the circuit comprising:
- a logic block (64) arranged to receive one or more digital signals representing the digital value and each one or more digital signals having a relative weighting, the logic block being further arranged to output one or more signals, each of said one or more output signals comprising an oscillator signal modulated by a respective digital signal;
- a generating means (69) for generating the analogue signal representative of the digital value, the analogue signal comprising a weighted combination of the one or more signals output from the logic block (64), wherein said generating means comprises a series of amplitude modifiers (62a-c) each associated with a respective one of said one or more output signals and arranged to relatively weight, based on the relative weightings of the respective digital signals, the relative amplitudes of the respective one or more output signals output from the logic block (64) **characterised by** a matching circuit (65) for matching the output impedance of said circuit to a value, wherein an input impedance of said circuit is lower than said matched output impedance value.

2. A circuit according to claim 1 in which the logic block (64) comprises a series of multiplying elements (61a-c), each multiplying element (61a-c) arranged to receive an oscillator signal as a first input and a respective digital signal as a second input, and arranged to multiply the oscillator signal with the digital signal.

3. A circuit according to claim 2 in which at least one multiplying element (61 a-c) comprises at least one of: a NAND gate, AND gate, OR gate, NOR gate, XOR gate, XNOR gate and series switches.

4. A circuit according to claim 1 in which at least one amplitude modifier (62a-c) comprises at least one of: a capacitor, a resistor and an inductor.

5. A circuit according to claims 1 to 4 in which the generating means (69) further comprises a means (66) to sum the amplitude-modified signals.

6. A circuit according to any preceding claim in which the one or more digital signals represent a binary number, and in which each digital signal has a binary weight.

7. A circuit according to any of claims 1 to 5 in which the one or more digital signals represent a thermometer-coded value, and in which each digital signal has equal weight.

8. A circuit according to any preceding claim in which the circuit comprises an I-branch (67) and a Q-branch (68), in which the I-branch (67) receives an I-component of digital data and the Q-branch (68) receives a Q-component of digital data, and in which the oscillator signal of the Q-branch (68) is 90° out of phase with the oscillator signal of the I-branch (67).

9. A circuit according to any of claims 2 to 8 in which at least one multiplying element (61 a-c) comprises:
- four inputs (81a-d), the first input (81 a) connected to a reference voltage, the second and third inputs (81b, 81c) being connected to the oscillator signal and the fourth input (81d) being connected to ground;
- four inverters (82a-d) for inverting the respective inputs (81a-d);
- four switches (83a-d) for selectively allowing the passage of the inverted inputs depending on the bit received by the multiplying element (61 a-c);
- a first series of inverters (84a, 84b) connected to the output of the first and second switches (83a, 83b) and a second series of inverters (84c, 84d) connected to the output of the third and fourth switches (83c, 83d).

10. A circuit according to claim 9 in which at least one amplitude modifier (62a-c) comprises: a first capacitor (85a) having a first plate connected to the output of the first series of inverters (84a, 84b) and a second capacitor (85b) having a first plate connected to the output of the second series of inverters (84c, 84d); a second plate of the first and second capacitors (85a, 85b) being connected together.

11. A circuit according to claim 9 or 10 in which one or more of the switches (83a-d) comprises a transistor switch.

12. A circuit according to any preceding claim in which the digital value is a signed digital value, and in which the oscillator signal comprises one of: a non-inverted oscillator signal; and an inverted oscillator signal depending on the sign of the digital value.

13. A transmitter comprising a circuit according to any preceding claim.

## Patentansprüche

1. Eine Schaltung zur Umsetzung eines Digitalwerts in ein Analogsignal, die Folgendes umfasst:
- einen zum Empfang eines oder mehrerer Digitalsignale angeordneten Logikblock (64), das/die den Digitalwert darstellt bzw. darstellen, wobei jedes des einen Digitalsignals oder der mehreren Digitalsignale eine relative Gewichtung hat und der Logikblock ferner zur Ausgabe eines oder mehrerer Signale angeordnet ist, wobei jedes einzelne des/der besagten Ausgangssignals bzw. der besagten mehreren Ausgangssignale ein Oszillatorsignal umfasst, das durch ein entsprechendes Digitalsignal moduliert wird;
- ein Erzeugungsmittel (69) zur Erzeugung des Analogsignals, das den Digitalwert darstellt, wobei das Analogsignal eine gewichtete Kombination des einen oder der mehreren Signale umfasst, das/die vom Logikblock (64) ausgegeben wird/werden, wobei besagtes Erzeugungsmittel eine Serie von Amplitudenmodifikatoren (62a-c) umfasst, die jeweils mit einem entsprechenden besagten Ausgangssignal oder mit besagten mehreren Ausgangssignalen verbunden und so angeordnet sind, um die relativen Amplituden des entsprechenden einen Ausgangssignals oder der entsprechenden mehreren Ausgangssignale, das/die vom Logikblock (64) ausgeben wird/werden, auf Basis der relativen Gewichtungen der entsprechenden Digitalsignale verhältnismäßig zu gewichten, **gekennzeichnet durch** eine Anpassungsschaltung(65), um die Ausgangsimpedanz der besagten Schaltung einem Wert anzupassen, bei welchem eine Eingangsimpedanz der besagten Schaltung niedriger ist als besagter angepasster Ausgangsimpedanzwert.

2. Eine Schaltung nach Anspruch 1, bei welcher der Logikblock (64) eine Serie von Multiplizierelementen (61a-c) umfasst, wobei jedes Multiplizierelement (61a-c) zum Empfang eines Oszillatorsignals als erster Eingang und eines entsprechenden Digitalsignals als zweiter Eingang, sowie zum Multiplizieren des Oszillatorsignals mit dem Digitalsignal angeordnet ist.

3. Eine Schaltung nach Anspruch 2, bei welcher mindestens ein Multiplizierelement (61a-c) mindestens eines der Folgenden umfasst: ein NAND-Gatter, AND-Gatter, ODER-Gatter, NOR-Gatter, XOR-Gatter, XNOR-Gatter und Serienschalter.

4. Eine Schaltung nach Anspruch 1, bei welcher mindestens ein Amplitudenmodifikator (62a-c) mindestens einen der Folgenden umfasst: einen Kondensator, einen Widerstand und einen Induktor.

5. Eine Schaltung nach Ansprüchen 1 bis 4, bei welcher das Erzeugungsmittel (69) ferner ein Mittel (66) zum Summieren der amplitudenmodifizierten Signale umfasst.

6. Eine Schaltung nach irgendeinem vorstehenden Anspruch, bei welcher das eine Digitalsignal oder mehrere Digitalsignale eine binäre Zahl darstellt bzw. darstellen und jedes Digitalsignal ein binäres Gewicht hat.

7. Eine Schaltung nach einem der vorstehenden Ansprüche 1 bis 5, bei welcher das eine Digitalsignal oder mehrere Digitalsignale einen thermometerkodierten Wert darstellt bzw. darstellen und jedes Digitalsignal von gleichem Gewicht ist.

8. Eine Schaltung nach irgendeinem vorstehenden Anspruch, die einen I-Zweig (67) und einen Q-Zweig (68) umfasst, wobei der I-Zweig (67) eine I-Komponente von Digitaldaten und der Q-Zweig (68) eine Q-Komponente von Digitaldaten empfangen und das Oszillatorsignal des Q-Zweigs (68) um 90° vom Oszillatorsignal des I-Zweigs (67) phasenverschoben ist.

9. Eine Schaltung nach einem der vorstehenden Ansprüche 2 bis 8, bei welcher mindestens ein Multiplizierelement (61a-c) Folgendes umfasst:
- vier Eingänge (81a-d), wobei der erste Eingang (81a) an eine Bezugsspannung angeschlossen ist, die zweiten und dritten Eingänge (81b, 81c) an das Oszillatorsignal angeschlossen sind und der vierte Eingang (81d) geerdet ist;
- vier Umrichter (82a-d) zum Invertieren der entsprechenden Eingänge (81a-d);
- vier Schalter (83a-d), um den Durchgang der invertierten Eingänge je nach dem vom Multiplikatorelement (61a-c) empfangenen Bit selektiv zu ermöglichen;
- eine erste Serie von Umrichtern (84a, 84b), die an den Ausgang der ersten und zweiten Schalter (83a, 83b) angeschlossen sind, und eine zweite Serie von Umrichtern (84c, 84d), die an den Ausgang der dritten und vierten Schalter (83c, 83d) angeschlossen sind.

10. Eine Schaltung nach Anspruch 9, bei welcher mindestens ein Amplitudenmodifikator (62a-c) Folgendes umfasst: einen ersten Kondensator (85a) mit einer ersten Platte, die an den Ausgang der ersten Serie von Umrichtern (84a, 84b) angeschlossen ist, und einen zweiten Kondensator (85b) mit einer ersten Platte, die an den Ausgang der zweiten Serie von Umrichtern (84c, 84d) angeschlossen ist; eine zweite Platte der ersten und zweiten Kondensatoren (85a, 85b), die miteinander verbunden sind.

11. Eine Schaltung nach Anspruch 9 oder 10, bei welcher einer oder mehrere der Schalter (83a-d) einen Transistorschalter umfasst bzw. umfassen.

12. Eine Schaltung nach irgendeinem vorstehenden Anspruch, bei welcher der Digitalwert ein signierter Digitalwert ist und das Oszillatorsignal eines der Folgenden umfasst: ein nicht-invertiertes Oszillatorsignal; und ein invertiertes Oszillatorsignal je nach der Signatur des Digitalwerts.

13. Ein Sender, der eine Schaltung nach irgendeinem vorstehenden Anspruch umfasst.

## Revendications

1. Un circuit de conversion d'une valeur numérique en un signal analogique, le circuit comprenant :
- un bloc logique (64) conçu pour recevoir un ou plusieurs signaux numériques représentant la valeur numérique et chaque ou plusieurs signaux numériques possédant une pondération relative, le bloc logique étant conçu en outre pour émettre un ou plusieurs signaux, chacun desdits un ou plusieurs signaux de sortie comprenant un signal d'oscillateur modulé par un signal numérique respectif ;
- un moyen de génération (69) pour générer le signal analogique représentatif de la valeur numérique, le signal analogique comprenant une combinaison pondérée du ou des plusieurs signaux émis par le bloc logique (64), dans lequel ledit moyen de génération comprend une série de modificateurs d'amplitude (62a-c) chacun associé avec un signal respectif desdits un ou plusieurs signaux de sortie et conçu pour pondérer relativement, basé sur les pondérations relatives des signaux numériques respectifs, les amplitudes relatives des un ou plusieurs signaux de sortie respectifs émis par le bloc logique (64) **caractérisé par** un circuit d'adaptation (65) pour adapter l'impédance de sortie dudit circuit à une valeur, dans lequel une impédance d'entrée dudit circuit est inférieure que ladite valeur d'impédance de sortie adaptée.

2. Un circuit selon la revendication 1 dans lequel le bloc logique (64) comprend une série d'éléments multiplicateurs (61a-c), chaque élément multiplicateur (61a-c) conçu pour recevoir un signal d'oscillateur en qualité de première entrée et un signal numérique respectif en qualité de seconde entrée, et conçu pour multiplier le signal d'oscillateur par le signal numérique.

3. Un circuit selon la revendication 2 dans lequel au moins un des éléments multiplicateurs (61a-c) comprend au moins une des suivantes : une porte NON-ET, une porte ET, une porte OU, une porte NI, une porte OU exclusif, une porte NI exclusif et des commutateurs en série.

4. Un circuit selon la revendication 1 dans lequel au moins un modificateur d'amplitude (62a-c) comprend au moins un des suivants : un condensateur, une résistance et un inducteur.

5. Un circuit selon les revendications de 1 à 4 dans lequel le moyen de génération (69) comprend en outre un moyen (66) pour additionner les signaux modifiés en amplitude.

6. Un circuit selon toute revendication précédente dans lequel le ou les plusieurs signaux numériques représentent un nombre binaire, et dans lequel chaque signal numérique possède un poids binaire.

7. Un circuit selon l'une quelconque des revendications de 1 à 5 dans lequel le ou les plusieurs signaux numériques représentent une valeur codée par thermomètre, et dans lequel chaque signal numérique possède un poids égal.

8. Un circuit selon toute revendication précédente dans lequel le circuit comprend une branche I (67) et une branche Q (68), dans lequel la branche I (67) reçoit une composante I de données numériques et la branche Q (68) reçoit une composante Q de données numériques, et dans lequel le signal d'oscillateur de la branche Q (68) est déphasé de 90° par rapport au signal d'oscillateur de la branche I (67).

9. Un circuit selon l'une quelconque des revendications de 2 à 8 dans lequel au moins un des éléments multiplicateurs (61a-c) comprend :
- quatre entrées (81a-d), la première entrée (81a) connectée à une tension de référence, les seconde et troisième entrées (81b, 81c) étant connectées au signal d'oscillateur et la quatrième entrée (81d) étant mise à la masse ;
- quatre onduleurs (82a-d) pour inverser les entrées respectives (81a-d) ;
- quatre commutateurs (83a-d) pour autoriser sélectivement le passage des entrées inversées en fonction du bit reçu par l'élément multiplicateur (61a-c) ;
- une première série d'onduleurs (84a, 84b) connectés à la sortie des premier et second commutateurs (83a, 83b) et une seconde série d'onduleurs (84c, 84d) connectés à la sortie des troisième et quatrième commutateurs (83c, 83d).

10. Un circuit selon la revendication 9 dans lequel au moins un modificateur d'amplitude (62a-c) comprend : un premier condensateur (85a) possédant une première plaque connectée à la sortie de la première série d'onduleurs (84a, 84b) et un second condensateur (85b) possédant une première plaque connectée à la sortie de la seconde série d'onduleurs (84c, 84d) ; une seconde plaque des premier et second condensateurs (85a, 85b) étant connectée l'une à l'autre.

11. Un circuit selon la revendication 9 ou 10 dans lequel un ou plusieurs des commutateurs (83a-d) comprend un commutateur à transistor.

12. Un circuit selon toute revendication précédente dans lequel la valeur numérique est une valeur numérique affectée d'un signe, et dans lequel le signal d'oscillateur comprend un des suivants : un signal d'oscillateur non-inversé ; et un signal d'oscillateur inversé en fonction du signe de la valeur numérique.

13. Un émetteur comprenant un circuit selon toute revendication précédente.
